# EUROPÄISCHE PATENTANMELDUNG

(11) **EP 0 599 438 A2**
(43) Veröffentlichungstag der Anmeldung: **01.06.1994**
(21) Anmeldenummer: 93250321.2
(22) Anmeldetag: 24.11.1993
(51) Int. Cl.: H02H 3/20, G01R 19/25

(54) **Verfahren und Vorrichtung zur Überwachung von periodischen Spannungssignalen**

(30) Priorität: 26.11.1992 DE 4239713
(71) Anmelder: AUCOTEAM Ingenieurgesellschaft für AUTOMATISIERUNGS- und COMPUTERTECHNIK mbH Berlin, D-10407 Berlin (DE)
(72) Erfinder: Klingner, Jürgen, D-74889 Sinsheim-Hilsbach (DE)
(74) Vertreter: Mittelberger, Peter

(57) **Zusammenfassung**

Zur Überwachung von periodischen Spannungssignalen, insbesondere Wechselspannungen, und davon abhängigen elektrischen Größen, bei dem mindestens ein Spannungssignal (MS) erfaßt und mit einem Sollsignal (SS) verglichen wird, indem ein Differenzsignal (DS) gebildet wird, ist erfindungsgemaß ein Verfahren vorgeschlagen worden, bei dem das Spannungssignal (MS) periodenweise mit dem Sollsignal (SS) verglichen wird, wobei das Sollsignal (SS) ein dem Spannungssignal (MS) entsprechendes ideales periodisches Signal ist. Das Differenzsignal (DS) wird für jede Signalperiode ausgewertet. Hierbei wird eine Klassifizierung vorgenommen, die Abweichungen des Spannungssignals (MS) vom Sollsignal (SS) definierten Störklassen zuordnet.

Es wird außerdem eine Vorrichtung zur Durchführung des Verfahrens vorgeschlagen, die an sich bekannte Merkmale, wie ein Netzteil, ein Anzeige-und Bedienteil, mindestens einen Spannungskanal als Eingang für das zu überwachende Spannungssignal (MS), einen Analog/Digital-Wandler für das Spannungssignal (MS), Speichereinrichtungen und mindestens eine Verarbeitungseinheit umfaßt. Erfindungsmäßig enthält die Verarbeitungseinheit mindestens einen Mikroprozessor, vorzugsweise einen programmierbaren Signalprozessor, zur Auswertung des Differenzsignals (DS) und insbesondere zur Klassifizierung der Abweichungen des Spannungssignals (MS) vom Sollsignal (SS).

## Beschreibung

Die Erfindung betrifft ein Verfahren zur Überwachung von periodischen Spannungssignalen, insbesondere Wechselspannungen, und davon abhängigen elektrischen Größen, bei dem mindestens ein Spannungssignal erfaßt und mit einem Sollsignal verglichen wird, in dem ein Differenzsignal gebildet wird, sowie eine Vorrichtung zur Durchführung eines solchen Verfahrens. Die Vorrichtung umfaßt ein Netzteil, ein Anzeige- und Bedienteil, mindestens einen Spannungskanal als Eingang für das zu überwachende Spannungssignal, einen Analog/Digital-Wandler für das Spannungssignal, Speichereinrichtungen und mindestens eine Verarbeitungseinheit.

Die genaue Kontrolle von Wechselspannungen ist beispielsweise beim Einsatz hochempfindlicher Computertechnologie von großer Bedeutung. Aus der Praxis sind bereits Geräte bekannt, mit denen es möglich ist, den Echt-Effektivwert der Netzspannung zu messen, wobei das Meßintervall, das heißt das Zeitintervall, für das der Effektivwert ermittelt wird, in weiten Grenzen frei einstellbar ist. Über-und Unterschreitungen eines Sollwertes für den Effektivwert, der individuell vorgegeben werden kann, werden erfaßt und gespeichert. Es sind außerdem Geräte bekannt, die zusätzlich transiente Spannungsspitzen erkennen und deren Häufigkeit abspeichern.

Die bekannten Geräte beruhen auf dem Prinzip der Echt-Effektivwerterfassung des Spannungssignals. Da der Effektivwert eines Signals eine Art Mittelwert über ein Zeitintervall darstellt, ist eine exakte Bestimmung des Zeitpunktes einer aufgetretenen Störung nicht möglich. Außerdem läßt sich mit dem bekannten Gerät lediglich feststellen, daß eine Störung in einem bestimmten Zeitintervall aufgetreten ist, aber nicht, um welche Art von Störung es sich gehandelt hat, also ob es sich beispielsweise um eine Transiente, einen Signaleinbruch oder auch eine Oberwelle gehandelt hat.

Aus dem DD-WP 218 474 A1 ist ein Verfahren bekannt geworden, mit Hilfe dessen Abweichungen von Momentanwerten periodischer Spannungsverläufe erkannt werden können, indem die Spannungsverläufe bezüglich vorgegebener Grenzwerte überwacht werden. Dazu wird der zu überwachende Spannungsverlauf mit einer oberen und einer unteren Grenzwertkurve mit Hilfe einer einen Komperator enthaltenen Auswerteschaltung verglichen, die ein Fehlersignal in Form eines Differenzsignals liefert.

Bei dem bekannten Verfahren ist also praktisch durch die obere und die untere Grenzwertkurve ein Toleranzbereich für das zu überwachende Spannungssignal definiert. Aufgabe und Ziel des bekannten Verfahrens ist es, die Erkennungszeit zu minimieren, welche als die maximale Zeitspanne vom Auftreten einer nicht mehr zu tolerierenden Abweichung des Spannungssignals bis zur Bereitstellung eines Steuersignals angenommen wird. Zum einen soll die Erkennungszeit immer möglichst klein sein, egal zu welchem Zeitpunkt bezogen auf eine Periode des Spannungssignals die Abweichung auftritt. Zum anderen soll, unabhängig von der Ursache der Abweichung, das heißt unabhängig von der Art der Störung des Spannungssignals, immer ein und dasselbe Steuersignal bereitgestellt werden, nämlich ein Signal zur geräteinternen Steuerung.

Das bekannte Verfahren ist in der Praxis problematisch, da es keine Möglichkeiten eröffnet, das zu überwachende Spannungssignal beziehungsweise die Abweichungen des Spannungssignals von einem diesem entsprechenden idealen periodischen Signal, dem Sollsignal, zu analysieren.

Rückschlüsse auf etwaige Fehlfunktionen von Geräten, die an die entsprechende Spannungsquelle beziehungsweise das entsprechende Netz angeschlossen sind und Zuordnungen bestimmter Fehlfunktionen zu bestimmten Störungen des überwachten Spannungssignals, sind bei dem bekannten Überwachungsverfahren nicht möglich.

Der Erfindung liegt die Aufgabe zugrunde, das Verfahren zur Erkennung von Abweichungen der Momentanwerte periodischer Spannungsverläufe so auszugestalten und weiterzubilden, daß zusätzlich eine Auswertung dieser Abweichungen ebenfalls mit möglichst geringem zeitlichen Versatz erfolgt.

Das erfindungsgemäße Verfahren löst die vorstehende Aufgabe durch die Merkmale des Patentanspruchs 1. Danach ist das Verfahren derart gestaltet, daß das Sollsignal ein dem Spannungssignal entsprechendes ideales periodisches Signal ist, daß das Spannungssignal periodenweise mit dem Sollsignal verglichen wird, indem das Spannungssignal abschnittsweise mit entsprechenden Abschnitten des Sollsignals verglichen wird, und daß das Differenzsignal für jede Signalperiode ausgewertet wird, wobei eine Klassifizierung vorgenommen wird, die Abweichungen des Spannungssignals vom Sollsignal definierten Störklassen zuordnet. Zur Durchführung des Verfahrens wird eine Vorrichtung mit den Merkmalen des Patentanspruches 19 vorgeschlagen, die an sich bekannte Merkmale, wie ein Netzteil, ein Anzeige- und Bedienteil, mindestens einen Spannungskanal als Eingang für das zu überwachende Spannungssignal, einen Analog/Digital-Wandler für das Spannungssignal, Speichereinrichtungen und mindestens eine Verarbeitungseinheit umfaßt. Erfindungsgemäß enthält die Verarbeitungseinheit mindestens einen Mikroprozessor, vorzugsweise einen programmierbaren Signalprozessor, zur Auswertung des Diffferenzsignals und insbesondere zur Klassifizierung der Abweichungen des Spannungssignals vom Sollsignal.

Erfindungsgemäß ist erkannt worden, daß sich die Ursachen für Abweichungen des Spannungssignals je nach den konkreten physikalischen Randbedingungen des Anwendungsfalls bestimmten Störungstypen zuordnen lassen. Es ist ferner erkannt worden, daß sich diese unterschiedlichen Ursachen in mehr oder weniger charakteristischen Abweichungen des Spannungssignals vom Sollsignal auswirken, welches als ein dem Spannungssignal entsprechendes ideales periodisches Signal angenommen wird. Erfindungsgemäß ist schließlich erkannt worden, daß eine Klassifizierung der Abweichungen des Spannungssignals vom Sollsignal als Auswertung geeignet ist, so daß Rückschlüsse auf die Ursachen für die Abweichungen und deren Wirkungen auf etwaig angeschlossene Geräte gezogen werden können.

Da das erfindungsgemäße Verfahren von periodischen Signalverläufen ausgeht, wird vorgeschlagen, das Spannungssignal in Abschnitten von jeweils einer Signalperiode mit dem Sollsignal zu vergleichen. Es hat sich gezeigt, daß die Auswertung des Differenzsignals dann mit einem systembedingten Zeitversatz von maximal einer Periode möglich ist. Mit dem erfindungsgemäßen Verfahren ist also praktisch eine Echtzeitüberwachung möglich.

Das reale Spannungssignal, insbesondere wenn es fehlerbehaftet beziehungsweise Schwankungen unterworfen ist, entspricht nicht einem ideal periodischen Signal. Es ist also erforderlich, einzelne Signalabschnitte des Spannungssignals als Periode zu definieren, die dann mit einer idealen Periode des Sollsignals verglichen werden können. Hinsichtlich einer einfachen Realisierung und der damit erzielten Ergebnisse ist es besonders vorteilhaft, wenn eine Periode des Spannungssignals jeweils als der Signalabschnitt zwischen zwei aufeinanderfolgenden Überschreitungen oder Unterschreitungen eines vorgebbaren Signalpegels bestimmt wird. Wahlweise kann hier als Signalpegel ein scharfer Grenzwert oder auch ein Toleranzintervall gewählt werden.

Im Falle eines sinusförmigen Signalverlaufs bietet sich beispielsweise der Nullpegel als Sinalpegel an. Als eine Periode wird dann der Signalabschnitt zwischen zwei Nulldurchgängen des Spannungssignals mit gleichen Vorzeichen, das heißt von positiv nach negativ oder von negativ nach positiv, bestimmt.

In einer vorteilhaften Ausgestaltung des erfindungsgemäßen Verfahrens wird das Spannungssignal bezüglich einem Nulleiter erfaßt. Dies ist insbesondere im Hinblick einer einfachen und übersichtlichen Auswertung des Spannungssignals vorteilhaft.

Die Auswertung des Spannungssignals beziehungsweise des Differenzsignals kann sowohl analog als auch digital erfolgen, wozu jeweils entsprechende Vorrichtungen erforderlich sind. Zur digitalen Verarbeitung wird das analog erfaßte Spannungssignal analog/digital gewandelt und periodenweise mit einem digitalisiert abgespeicherten Sollsignal verglichen. Diese Vergleichs-Operation läßt sich bei digital vorliegenden Daten wesentlich schneller ausführen, als wenn sowohl das Spannungssignal als auch das Sollsignal in analoger Form vorliegen.

In einer besonders bevorzugten Realisierung des erfindungsgemäßen Verfahrens werden Störungen des Spannungssignals nicht nur erfaßt und deren genaues Auftreten im Kurvenverlauf des Spannungssignals detektiert, solche Störungen werden auch klassifiziert, das heißt definierten Störklassen zugeordnet. Je nach der verwendeten Vorrichtung zur Durchführung des erfindungsgemäßen Verfahrens kann der Benutzer sich individuell auf die jeweilige Anwendung zugeschnittene Störklassen definieren. Üblicherweise handelt es sich jedoch um die Störklassen: Signaleinbruch, Transiente und/oder Oberwellen. Es ist nun also möglich, das Spannungssignal dahingehend statistisch auszuwerten, daß sämtliche Abweichungen des Spannungssignals vom Sollsignal mit dem Zeitpunkt ihres Auftretens erfaßt und einer gewissen Störklasse zugeordnet werden können.

Von besonderem Vorteil ist es, wenn das Spannungssignal wahlweise, vorzugsweise in Abhängigkeit des Grades der Abweichung des Spannungssignals vom Sollsignal beziehungsweise vom Ausmaß der Störung, periodenweise abgespeichert wird. Das heißt, daß besonders gestörte Signalabschnitte abgespeichert werden und gegebenenfalls einer zusätzlichen Analyse unterzogen werden können.

Auch die Visualisierung solcher Signalverläufe ist oftmals sehr aufschlußreich. In Verbindung mit dem Zeitpunkt der Erfassung solcher Signalabschnitte können dann Rückschlüsse auf etwaige Fehlfunktionen von an die entsprechende Spannungsquelle beziehungsweise das entsprechende Netz angeschlossenen Geräten gezogen werden.

Wie vorab beschrieben, können mit dem erfindungsgemäßen Verfahren und vorteilhaften Ausgestaltungen dieses Verfahrens sowohl Signaleinbrüche, Transienten als auch Oberwellen erfaßt werden.

Im folgenden werden vorteilhafte Weiterbildungen des erfindungsgemäßen Verfahrens beschrieben, mit denen weitere Kenngrößen des Spannungssignals erfaßt und Störungen anderer Art ermittelt werden können.

Für viele technische Anwendungen wird in der Praxis Drehstrom verwendet. Es ist daher vorteilhaft, wenn mehrere, vorzugsweise drei, Spannungssignale gleichzeitig überwacht werden können. Wesentlich für den einwandfreien Betrieb von durch Drehstrom angetriebenen Geräten ist eine exakte Phasenverschiebung zwischen den einzelnen Spannungssignalen von 1200. In einer vorteilhaften Weiterbildung des erfindungsgemäßen Verfahrens besteht daher auch die Möglichkeit, die Phasen der Spannungssignale beziehungsweise die Phasenverschiebungen der Spannungssignale zueinander zu erfassen.

Niederfrequente Schwankungen des Spannungssignals, das sogenannte Flickern, lassen sich durch Ermittlung und Überwachung des Effektivwertes des Spannungssignals erfassen. In einer vorteilhaften Weiterbildung des erfindungsgemäßen Verfahrens besteht daher die Möglichkeit, den Effektivwert des Spannungssignals in einem vorgebbaren Zeitintervall zu ermitteln und auszuwerten.

Weitere Störungen des Spannungssignals können beispielsweise dadurch auftreten, daß der Nulleiter, gegen den das Spannungssignal gemessen wird, nicht auf einem definierten Potential liegt. Daher wird in einer vorteilhaften Ausgestaltung des erfindungsgemäßen Verfahrens die Spannung zwischen dem Nulleiter und einem Schutzleiter gemessen, erfaßt und gegebenenfalls ausgewertet.

Natürlich lassen sich mit dem erfindungsgemäßen Verfahren auch von der Wechselspannung abhängige elektrische Größen wie das Stromsignal sowie die anliegende Leistung ermitteln und überwachen.

Wie bereits angedeutet, läßt sich das erfindungsgemäße Verfahren besonders schnell und störunanfällig mit digitalisiert vorliegenden Signalen durchführen. Es wird nun vorgeschlagen, das digitalisierte Spannungssignal mindestens einem Microprozessor, vorzugsweise einem programmierbaren Signalprozessor, zuzuführen und die weitere Verarbeitung und Auswertung des Spannungssignals im wesentlichen mit Hilfe des Microprozessors durchzuführen. Dieser kann dann beispielsweise auch die Übertragung der übermittelten Daten zu einer übergeordneten Einheit vorbereiten.

Für den Benutzer des erfindungsgemäßen Verfahrens ist es von besonderem Vorteil, wenn diese übergeordnete Einheit nicht nur als Speichermedium und zur Weiterverarbeitung der ermittelten Daten dient, sondern diese Daten auch mit Hilfe der übergeordneten Einheit visualisiert werden können. Als übergeordnete Einheit kommt beispielsweise ein Personalcomputer mit einem Bildschirm in Frage, auf dem dann die Kurvenverläufe von kritischen Signalabschnitten dargestellt werden könnten. Es ist auch eine numerische Darstellung der Meßdaten möglich, die dann beispielsweise mit Hilfe eines Druckers ausgedruckt werden könnten.

Es gibt nun viele Möglichkeiten zur Realisierung einer Vorrichtung, mit Hilfe derer eine Variante des erfindungsgemäßen, vorab beschriebenen Verfahrens durchgeführt werden könnte. Es wird im folgenden daher darauf verzichtet, eine konkrete Schaltungsanordnung mit den genauen Bezeichnungen der verwendeten elektronischen Bauteile anzugeben. Wesentlich ist, daß die Vorrichtung ein Netzteil, ein Anzeige- und Bedienteil, mindestens einen Spannungskanal als Eingang für das zu überwachende Spannungssignal, Speichereinrichtungen und mindestens eine Verarbeitungseinheit aufweist.

Erfindungsgemäß wird vorgeschlagen, einen an sich bekannten Analog/Digital-Wandler für das Spannungssignal und mindestens einen Microprozessor, vorzugsweise einen programmierbaren Signalprozessor, als Bestandteil der Verarbeitungseinheit, vorzusehen. Da es sich bei den vorab beschriebenen Operationen zur Auswertung des Spannungssignals, wie zum Beispiel die Bildung eines Differenzsignals oder die Berechnung des Effektivwertes des Signals, um typische standardmäßig im Bereich der Signalverarbeitung auftretenden Einzeloperationen handelt, ist es vorteilhaft, diese Operationen in einem dafür ausgelegten Signalprozessor durchzuführen. Dieser ist dann entsprechend zu programmieren.

In einer besonders vorteilhaften Ausführungsform verfügt das Netzteil der erfindungsgemäßen Vorrichtung über eine automatische Netzfrequenzanpassung. Dadurch ist die Vorrichtung besonders vielfältig verwendbar und einfach bedienbar.

Um nun auch im Falle eines Netzausfalls einsatzfähig zu sein, kann die Vorrichtung über einen Akku, eine Batterie, Solarzellen und/oder andere geeignete Mittel zur Energieversorgung verfügen.

Dabei eignet sich besonders ein Akku, da dieser automatisch bei Normalbetrieb über die Netzspannung wieder aufgeladen wird und daher stets zur Notversorgung der Vorrichtung bereit ist.

Besonders bedienungsfreundlich sind Vorrichtungen zur Überwachung von Wechselspannungen, die über ein Anzeige- und Bedienteil mit einer LC-Anzeige verfügen. Darüber können dem Benutzer Bedienhilfen gegeben werden, wie beispielsweise Angaben über die Funktion bestimmter Tastenkombinationen.

Wie bereits voranstehend in Verbindung mit dem erfindungsgemäßen Verfahren beschrieben, ist es von besonderem Vorteil, wenn die Vorrichtung über mehrere Spannungskanäle, insbesondere drei Spannungskanäle, als Eingänge für die Spannungssignale verfügt und zusätzlich über mindestens einen Nulleitereingang und/oder mindestens einen Schutzleitereingang. In diesem Falle kann beispielsweise auch die Spannung zwischen dem Nulleiter und dem Schutzleiter gemessen werden und Rückschlüsse aus diesem Spannungsverlauf auf etwaig auftretende Störungen des zu überwachenden Spannungssignals gezogen werden.

Um nun die Bedienung einer Vorrichtung mit mehreren Eingängen unterschiedlicher Funktion so einfach wie möglich zu gestalten, ist es vorteilhaft, wenn alle Eingänge symmetrisch ausgelegt sind. In diesem Falle ist es irrelevant, ob der Benutzer versehentlich den Nulleiter an einen Spannungskanal anschließt beziehungsweise ein zu überwachendes Spannungssignal auf den Nulleitereingang legt. Die Funktionsfähigkeit der Vorrichtung bleibt in jedem Fall gewährleistet.

Damit auch der Zeitpunkt des Erfassens eines bestimmten Signalabschnittes festgehalten werden kann, weist eine vorteilhafte Ausgestaltung der erfindungsgemäßen Vorrichtung eine Uhr - vorzugsweise mit Datumsfunktion - auf.

Von besonderem Vorteil ist es nun, wenn die erfindungsgemäße Vorrichtung auch mit mindestens einer Schnittstelle für eine übergeordnete Einheit ausgestattet ist. Eine übergeordnete Einheit kann beispielsweise ein Personalcomputer sein, mit Hilfe dessen weitere Prozesse, Geräte oder Maschinen, die in Verbindung mit der überwachten Wechselspannung stehen, gesteuert werden können. Die Vorrichtung kann dazu beispielsweise über eine serielle Schnittstelle verfügen. Eine parallele Schnittstelle kann vorteilhafterweise zum Anschluß eines Druckers vorgesehen sein, der Meßdaten oder auch Kurvenverläufe ausdrucken kann.

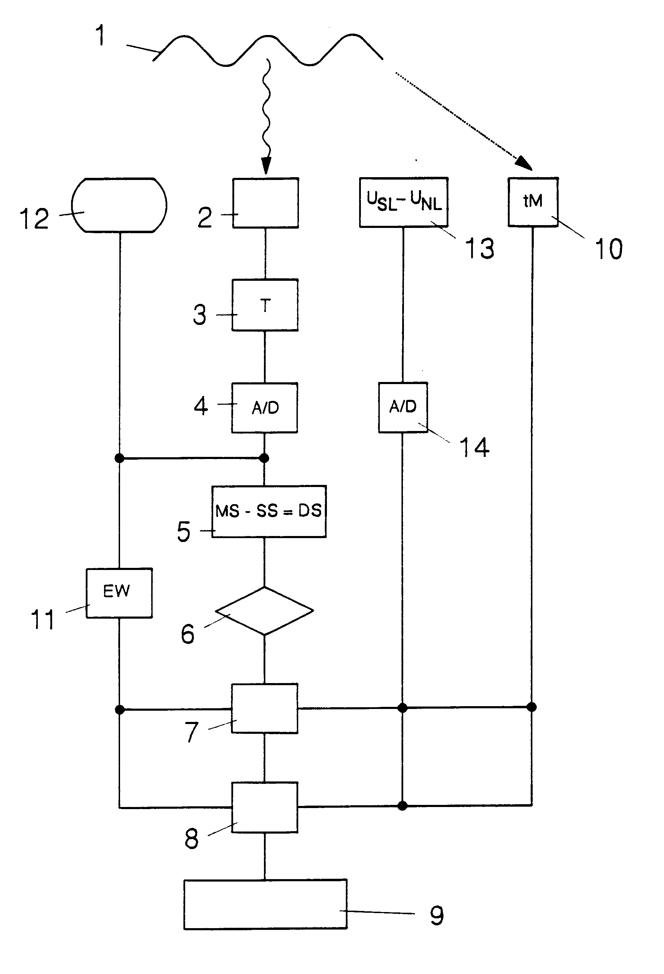

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 sowie dem Patentanspruch 19 nachgeordneten Ansprüche, andererseits auf die nachfolgende Erläuterung eines Ausführungsbeispiels der Erfindung anhand der Zeichnung zu verweisen. In Verbindung mit der Erläuterung des bevorzugten Ausführungsbeispiels der Erfindung anhand der Zeichnung werden auch im allgemeinen bevorzugte Ausgestaltungen und Weiterbildungen der Lehre erläutert.

Die Zeichnung zeigt in einem schematischen Ablaufdiagramm ein Ausführungs-beispiel des erfindungsgemäßen Verfahrens zur Überwachung von Wechselspannungen und davon abhängigen elektrischen Größen.

Das Ablaufdiagramm zeigt ein zu überwachendes Spannungssignal 1, das im folgenden auch als Spannungssignal MS bezeichnet wird. Erfindungsgemäß wird dieses Spannungssignal MS zunächst erfaßt.

Dies kann beispielsweise durch Anlegen des zu überwachenden Spannungssignals MS an den Eingang einer entsprechenden Vorrichtung erfolgen. Im Ablaufdiagramm ist der Vorgang des Erfassens als Verfahrensschritt 2 bezeichnet. Erfindungsgemäß wird das erfaßte Spannungssignal MS periodenweise mit einem Sollsignal SS verglichen, das vorteilhafterweise in der Meßvorrichtung abge-

speichert ist. Dieser Vergleich besteht in einer Differenzbildung zwischen dem Spannungssignal MS und dem Sollsignal SS und resultiert in einem Differenzsignal DS. Die Differenzbildung erfolgt in dem Verfahrensschritt 5. Das Differenzsignal DS wird in einem weiteren Verfahrensschritt 6 ausgewertet.

In dem Ausführungsbeispiel wird nach dem Erfassen des Spannungssignals MS in dem Verfahrensschritt 2 das Spannungssignal MS zunächst in Signalabschnitte aufgeteilt, die jeweils mit einer Periode des Sollsignals SS verglichen werden. Dazu werden jeweils zwei aufeinanderfolgende Nulldurchgänge des Spannungssignals MS mit gleichem Vorzeichen bestimmt. Der dazwischenliegende Signalabschnitt wird als eine Periode des Spannungssignals MS definiert. In einem anschließenden Verfahrensschritt 4 wird dieser Signalabschnitt dann analog/digital gewandelt, bevor er mit einer entsprechenden Periode des Sollsignals SS verglichen wird beziehungsweise das Differenzsignal DS im Verfahrensschritt 5 ermittelt wird. Die Auswertung 6 des Differenzsignals DS besteht nun in einer Klassifizierung der Abweichungen des Spannungssignals MS vom Sollsignal SS. Die Abweichungen werden beispielsweise den Störklassen Signaleinbruch, Transiente und/oder Oberwellen zugeordnet. In einem folgenden Verfahrensschritt 7 werden diese klassifizierten Abweichungen zusammen mit dem Zeitpunkt tM ihres Auftretens abgespeichert. Dieser Zeitpunkt tM wird beispielsweise über eine interne Uhr der Meßvorrichtung jeweils mit dem Erfassen 2 eines Signalabschnitts in einem Verfahrensschritt 10 festgehalten.

Parallel zu dem voranstehend beschriebenen Verfahren zur Ermittlung und Auswertung des Differenzsignals DS wird die Spannung zwischen einem ebenfalls an die Meßvorrichtung angeschlossenen Schutzleiter SL und dem Nulleiter NL bestimmt, bezüglich dessen das Spannungssignal MS erfaßt wird. Im Idealfalle ist die Spannung zwischen dem Schutzleiter SL und dem Nulleiter NL 0.

Abweichungen davon ermöglichen Rückschlüsse auf auftretende Störungen des Spannungssignals MS. Die in einem Verfahrensschrit 13 bestimmte Differenz zwischen den Spannungen des Schutzleiters SL und des Nulleiters NL kann wahlweise ebenfalls in einem Verfahrensschritt 14 analog/digital gewandet werden und in digitalisierter Form ausgewertet werden. Auch diese Resultate werden im Verfahrensschritt 7 abgespeichert.

Des weiteren parallel zu den vorab beschriebenen Messungen wird in einem Verfahrensschritt 11 der Effektivwert EW des Spannungssignals MS über eine in einem Eingabeschritt 12 vorgebbare Zeitdauer bestimmt. Auch dieser Effektivwert EW wird im Verfahrensschritt 7 abgespeichert. An die Abspeicherung 7 kann sich nun eine Übertragung zu einer übergeodneten Einheit anschließen, die hier im Verfahrensschritt 8 durchgeführt wird. In der übergeordneten Einheit in einem Verfahrensschritt 9 werden die ermittelten Daten nun weiterverarbeitet. Eine Weiterverarbeitung kann in unterschiedlichster Form erfolgen. Beispielsweise können die ermittelten Daten zur Steuerung eines angeschlossenen Prozesses dienen. Die Daten können aber auch einfach visualisiert werden, so daß dem Benutzer selbst eine Interpretation der Meßdaten möglich ist.

Hinsichtlich weiterer in dem Ablaufdiagramm nicht gezeigter Verfahrensschritte und Merkmale wird auf den allgemeinen Teil der Beschreibung verwiesen.

Abschließend sei hervorgehoben, daß die erfindungsgemäße Lehre nicht auf das voranstehend erörterte Ausführungsbeispiel eines Verfahrens zur Überwachung von Wechselspannungen beschränkt ist. Die erfindungsgemäße Lehre läßt sich auch zur Überwachung von anders gearteten periodischen Spannungsverläufen anwenden.

### Aufstellung der verwendeten Bezugszeichen

1 Spannungssignal MS
2 Erfassen des Spannungssignals
3 Periodenbestimmung
4 Analog/Digital-Wandlung
5 Bildung des Differenzsignals DS
6 Zuordnung zu Störklassen
7 Abspeicherung
8 Übertragung
9 Visualisierung
10 Zeitpunkterfassung
11 Bildung des Effektivwerts EW
12 Eingabe eines Zeitintervalls
13 Spannungsmessung zwischen Schutzleiter SL und Nulleiter NL
14 Analog/Digital-Wandlung
MS Spannungssignal
SS Sollsignal
DS Differenzsignal
EW Effektivwert
tM Zeitpunkt der Signalerfassung
SL Schutzleiter
NL Nulleiter

## Patentansprüche

1. Verfahren zur Überwachung von periodischen Spannungssignalen, insbesondere Wechselspannungen, und davon abhängigen elektrischen Größen, bei dem mindestens ein Spannungssignal (MS) erlaßt und mit einem Sollsignal (SS) verglichen wird, indem ein Differenzsignal (DS) gebildet wird, dadurch gekennzeichnet, daß das Sollsignal (SS) ein dem Spannungssignal (MS) entsprechendes ideales periodisches Signal ist, daß das Spannungssignal (MS) periodenweise mit dem Sollsignal (SS) verglichen wird, indem das Spannungssignal (MS) abschnittsweise mit entsprechenden Abschnitten des Sollsignals (SS) verglichen wird, und daß das Differenzsignal (DS) für jede Signalperiode ausgewertet wird, wobei eine Klassifizierung erfolgt, die Abweichungen des Spannungssignals (MS) vom Sollsignal (SS) definierten Störklassen zuordnet.

2. Verfahren nach Anspruch 1, dadurch gekennzeichnet, daß als eine Periode (T) des Spannungssignals (MS) jeweils der Signalabschnitt zwischen zwei aufeinanderfolgenden Überschreitungen oder Unterschreitungen eines vorgebbaren Signalpegels bestimmt wird, vorzugsweise als der Signalabschnitt zwischen zwei Nulldurchgängen des Spannungssignals (MS) mit gleichen Vorzeichen.

3. Verfahren nach einem der Ansprüche 1 oder 2, dadurch gekennzeichnet, daß das Spannungssignal (MS) bezüglich einem Nulleiter (NL) erfaßt wird.

4. Verfahren nach einem der Ansprüche 1 bis 3, dadurch gekennzeichnet, daß das Spannungssignal (MS) analog/digital gewandelt wird und periodenweise mit einem digitalisiert abgespeicherten Sollsignal (SS) verglichen wird.

5. Verfahren nach einem der Ansprüche 1 bis 4, dadurch gekennzeichnet, daß die Abweichungen des Spannungssignals (MS) vom Sollsignal (SS) den Störklassen Signaleinbruch, Transiente und/oder Oberwellen zugeordnet werden.

6. Verfahren nach einem der Ansprüche 1 bis 5, dadurch gekennzeichnet, daß der Zeitpunkt (tM) der Erfassung des Spannungssignals (MS) festgehalten wird.

7. Verfahren nach einem der Ansprüche 1 bis 6, dadurch gekennzeichnet, daß das Spannungssignal (MS) wahlweise, in Abhängigkeit des Grades der Abweichung des Spannungssignals (MS) vom Sollsignal (SS), periodenweise abgespeichert wird.

8. Verfahren nach Anspruch 7, dadurch gekennzeichnet, daß das Spannungssignal (MS) in Verbindung mit dem Zeitpunkt (tM) seiner Erfassung abgespeichert wird.

9. Verfahren nach einem der Ansprüche 1 bis 8, dadurch gekennzeichnet, daß mehrere, vorzugsweise drei, Spannungssignale (MS) erfaßt werden.

10. Verfahren nach Anspruch 9, dadurch gekennzeichnet, daß die Phasen der Spannungssignale (MS) bzw. die Phasenverschiebungen der Spannungssignale (MS) zueinander erfaßt werden.

11. Verfahren nach einem der Ansprüche 1 bis 10, dadurch gekennzeichnet, daß der Effektivwert (EW) des Spannungssignals (MS) in einem vorgebbaren Zeitintervall ermittelt und ausgewertet wird.

12. Verfahren nach einem der Ansprüche 3 bis 11, dadurch gekennzeichnet, daß die Spannung zwischen dem Nulleiter (NL) und einem Schutzleiter (SL) gemessen, erfaßt und ausgewertet wird.

13. Verfahren nach einem der Ansprüche 1 bis 12, dadurch gekennzeichnet, daß mit Hilfe des erfaßten Spannungssignals (MS) das anliegende Stromsignal ermittelt und überwacht wird.

14. Verfahren nach einem der Ansprüche 1 bis 13, dadurch gekennzeichnet, daß mit Hilfe des erfaßten Spannungssignals (MS) die anliegende Leistung ermittelt und überwacht wird.

15. Verfahren nach einem der Ansprüche 4 bis 14, dadurch gekennzeichnet, daß das digitalisierte Spannungssignal (MS) mindestens einem Microprozessor, vorzugsweise einem programmierbaren Signalprozessor, zugeführt wird und daß die weitere Verarbeitung und Auswertung des Spannungssignals (MS) im wesentlichen durch den Microprozessor erfolgt.

16. Verfahren nach einem der Ansprüche 1 bis 15, dadurch gekennzeichnet, daß die erfaßten, ausgewerteten und gegebenenfalls abgespeicherten Daten an eine übergeordnete Einheit übertragen werden.

17. Verfahren nach Anspruch 16, daß die Daten mit Hilfe der übergeodneten Einheit visualisiert werden.

18. Verfahren nach Anspruch 17, dadurch gekennzeichnet, daß der Verlauf des Spannungssignals (MS) in Form eines Kurvenzuges wahlweise, in Abhängigkeit des Grades der Abweichung des Spannungssignals (MS) vom Sollsignal (SS), periodenweise visualisiert wird.

19. Vorrichtung zur Durchführung eines Verfahrens nach einem der Ansprüche 1 bis 18, umfassend ein Netzteil, ein Anzeige- und Bedienteil, mindestens einen Spannungskanal als Eingang für das zu überwachende Spannungssignal, einen Analog/Digital-Wandler für das Spannungssignal, Speichereinrichtungen und mindestens eine Verarbeitungseinheit, dadurch gekennzeichnet, daß die Verarbeitungseinheit mindestens einen Microprozessor, vorzugsweise einen programmierbaren Signalprozessor, zur Auswertung des Differenzsignals (DS) und insbesondere zur Klassifizierung der Abweichungen des Spannungssignals (MS) vom Sollsignal (SS) umfaßt.

20. Vorrichtung nach Anspruch 19, dadurch gekennzeichnet, daß eine automatische Netzfrequenzanpassung des Netzteils vorgesehen ist.

21. Vorrichtung nach einem der Ansprüche 19 oder 20, dadurch gekennzeichnet, daß ein Akku, eine Batterie und/oder eine Solarzelle vorgesehen sind.

22. Vorrichtung nach einem der Ansprüche 19 bis 21, dadurch gekennzeichnet, daß das Anzeige-und Bedienteil eine LC-Anzeige umfaßt.

23. Vorrichtung nach einem der Ansprüche 19 bis 22, dadurch gekennzeichnet, daß mindestens ein Nulleitereingang und/oder mindestens ein Schutzleitereingang vorgesehen sind.

24. Vorrichtung nach einem der Ansprüche 19 bis 23, dadurch gekennzeichnet, daß der Spannungskanal, der Nulleitereingang und der Schutzleitereingang symmetrisch ausgelegt sind.

25. Vorrichtung nach einem der Ansprüche 19 bis 24, dadurch gekennzeichnet, daß eine Uhr vorzugsweise mit Datumsfunktion vorgesehen ist.

26. Vorrichtung nach einem der Ansprüche 19 bis 25, dadurch gekennzeichnet, daß eine serielle Schnittstelle zum Anschluß eines Personalcomputers und/oder eine parallele Schnittstelle zum Anschluß eines Druckers vorgesehen ist.
